(19) Europäisches Patentamt

European Patent Office

Office européen des brevets

(11) **EP 4 083 705 A1**

(12) **EUROPEAN PATENT APPLICATION**
published in accordance with Art. 153(4) EPC

(43) Date of publication:
**02.11.2022 Bulletin 2022/44**

(21) Application number: **21760516.1**

(22) Date of filing: **16.02.2021**

(51) International Patent Classification (IPC):
**G03F 1/62** *(2012.01)*          **G03F 7/20** *(2006.01)*

(52) Cooperative Patent Classification (CPC):
**G03F 1/62; G03F 7/20**

(86) International application number:
**PCT/JP2021/005738**

(87) International publication number:
**WO 2021/172104 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2020   JP 2020030942**

(71) Applicant: **Mitsui Chemicals, Inc.**
**Tokyo 105-7122 (JP)**

(72) Inventors:
  • **OKUBO, Atsushi**
    **Sodegaura-shi, Chiba 299-0265 (JP)**
  • **KOHMURA, Kazuo**
    **Otake-shi, Hiroshima 739-0601 (JP)**
  • **ISHIKAWA, Hisako**
    **Sodegaura-shi, Chiba 299-0265 (JP)**
  • **ONO, Yosuke**
    **Sodegaura-shi, Chiba 299-0265 (JP)**
  • **FUJII, Yasuhisa**
    **Kyoto-shi, Kyoto 600-8813 (JP)**
  • **YOSHIKAWA, Wataru**
    **Kyoto-shi, Kyoto 600-8813 (JP)**
  • **MATSUMOTO, Nobuko**
    **Kyoto-shi, Kyoto 600-8813 (JP)**
  • **DEGUCHI, Tomoe**
    **Kyoto-shi, Kyoto 600-8813 (JP)**

(74) Representative: **Hoffmann Eitle**
**Patent- und Rechtsanwälte PartmbB**
**Arabellastraße 30**
**81925 München (DE)**

(54) **PELLICLE FILM, PELLICLE, ORIGINAL PLATE FOR EXPOSURE, EXPOSURE DEVICE, METHOD FOR PRODUCING PELLICLE, AND METHOD FOR PRODUCING SEMICONDUCTOR DEVICE**

(57)    Provided are a pellicle film, a pellicle, an original plate for exposure, an exposure device, a method of producing a semiconductor device, and a method of producing a pellicle, the pellicle film containing carbon nanotubes having a silicon carbide layer in which at least a part of carbon is substituted with silicon at least on a surface layer side.

FIG.1

EP 4 083 705 A1

**Description**

Technical Field

The present disclosure relates to a pellicle film, a pellicle, an original plate for exposure, an exposure device, a method of producing a pellicle, and a method of producing a semiconductor device.

Background Art

A pellicle film used for a pellicle is usually produced by disposing a layer of silicon nitride (SiN) or the like on a silicon wafer substrate.

On the other hand, examples of a material having excellent transparency and resistance to light (such as EUV light) include carbon nanotubes, and development of a pellicle employing a carbon nanotube film has been advanced.

For example, Patent Document 1 discloses an EUV pellicle employing a carbon nanotube film.

In addition, Patent Document 2 discloses an EUV pellicle that forms a coating on a carbon nanotube film.

Patent Document 1: WO 2014/142125 A
Patent Document 2: Japanese Patent Application Laid-Open (JP-A) No. 2018-194840

SUMMARY OF INVENTION

Technical Problem

Since carbon nanotubes exhibit excellent strength, it is considered that the strength of a pellicle film can be improved by using carbon nanotubes for a pellicle.

However, the inventors of the disclosure have found that when a pellicle film employing carbon nanotubes is attached to an exposure device and used, hydrogen radicals generated from hydrogen often used in exposure devices reduce the strength of the carbon nanotubes.

On the other hand, for example, when it is attempted to impart hydrogen radical resistance to a pellicle film by using a carbon nanotube having a coating formed on a surface of the carbon nanotube as a pellicle film, the diameter of the carbon nanotube is increased by the coating, and thus there is a possibility that the light transmittance of the pellicle film decreases.

As described above, it has been difficult to achieve both hydrogen radical resistance and light transmittivity of the pellicle film.

An object of an embodiment of the disclosure is to provide a pellicle film that is excellent in hydrogen radical resistance and light transmittance at the time of EUV exposure, a pellicle, an original plate for exposure, an exposure device, and a method of producing a semiconductor device using the original plate for exposure.

An object of another embodiment of the disclosure is to provide a method of producing a pellicle excellent in hydrogen radical resistance and light transmittance at the time of EUV exposure.

Solution to Problem

Specific means for solving the above problems include the following aspects.

<1> A pellicle film containing carbon nanotubes having a silicon carbide layer in which at least a part of carbon is substituted with silicon at least on a surface layer side.

<2> The pellicle film according to <1>, in which a content of the silicon carbide layer is in a range of from 10% by mass to 100% by mass with respect to a total mass of the carbon nanotubes.

<3> The pellicle film according to <1> or <2>, in which a thickness of the film is from 2 nm to 200 nm (preferably from 10 nm to 200 nm).

<4> The pellicle film according to any one of <1> to <3>, in which a diameter of a tube in the carbon nanotubes is from 0.8 nm to 400 nm.

<5> The pellicle film according to any one of <1> to <4>, in which the carbon nanotubes are single-walled carbon nanotubes or multi-walled carbon nanotubes.

<6> The pellicle film according to <5>, in which a thickness of a bundle in the single-walled carbon nanotubes is from 4 nm to 400 nm.

<7> The pellicle film according to <5>, in which a filament of the multi-walled carbon nanotubes has a thickness of from 4 nm to 400 nm.

<8> The pellicle film according to any one of <1> to <7>, which is used for exposure using EUV light.

<9> A pellicle including: the pellicle film according to any one of <1> to <8>; and a support frame supporting the pellicle film.

<10> An original plate for exposure including: an original plate having a pattern; and the pellicle according to <9> attached to a surface of the original plate on a side having the pattern.

<11> An exposure device including: a light source configured to emit exposure light; the original plate for exposure according to <10>; and an optical system configured to guide the exposure light emitted from the light source to the original plate for exposure, in which the original plate for exposure is disposed such that the exposure light emitted from the light source passes through the pellicle film and is applied to the original plate.

<12> A method of producing a pellicle, the method including: preparing carbon nanotubes; forming the carbon nanotubes into a sheet shape to produce a carbon nanotube sheet; connecting the carbon nanotube sheet to a support frame having an opening so as to cover the opening to produce a pellicle precursor; and disposing the pellicle precursor and Si-containing particles in a chamber and heating the chamber at a heating temperature of from 1,200°C to 1,700°C for a heating time of from 5 minutes to 120 minutes.

<13> A method of producing a semiconductor device, the method including: allowing exposure light emitted from a light source to pass through the pellicle film of the original plate for exposure according to <10>, to be applied to the original plate, and to be reflected by the original plate; and allowing the exposure light reflected by the original plate to pass through the pellicle film and to be applied to a sensitive substrate to expose the sensitive substrate in a pattern.

Advantageous Effects of Invention

An embodiment of the disclosure can provide a pellicle film that is excellent in hydrogen radical resistance and light transmittance at the time of EUV exposure, a pellicle, an original plate for exposure, an exposure device, and a method of producing a semiconductor device using the original plate for exposure.

Another embodiment of the disclosure can provide a method of producing a pellicle excellent in hydrogen radical resistance and light transmittance at the time of EUV exposure.

BRIEF DESCRIPTION OF DRAWINGS

Fig. 1 is a graph showing the relationship between the temperature T of a pellicle film and the emissivity $\varepsilon$ of the pellicle film.

Fig. 2 is a graph showing the relationship between the temperature T of the pellicle film and the EUV transmittance Tr of the pellicle film.

Fig. 3 is a schematic cross-sectional view of a pellicle of the disclosure.

Fig. 4 is a schematic cross-sectional view of an EUV exposure device, which is an example of an exposure device of the disclosure.

DESCRIPTION OF EMBODIMENT

In the disclosure, a numerical range indicated using "to" means a range including numerical values described before and after "to" as the minimum value and the maximum value, respectively.

In a numerical range described in stages in the disclosure, the upper limit value or the lower limit value described in a certain numerical range may be replaced with the upper limit value or the lower limit value of another numerical range described in stages. In addition, in the numerical range described in the disclosure, the upper limit value or the lower limit value described in a certain numerical range may be replaced with a value shown in examples.

In the disclosure, a combination of two or more preferable aspects is a more preferable aspect.

In the disclosure, when there are plural kinds of substances corresponding to each component, the amount of each component means the total amount of the plural kinds of substances unless otherwise specified.

In the disclosure, the term "step" includes not only an independent step but also a step that cannot be clearly distinguished from other steps as long as the purpose of the step is achieved.

«Pellicle Film»

A pellicle film of the disclosure (hereinafter also simply referred to as a pellicle film) contains carbon nanotubes containing a silicon carbide layer in which at least a part of carbon is substituted with silicon at least on the surface layer side (also simply referred to as "silicon-containing carbon nanotubes" in the present specification).

The pellicle film of the disclosure contains silicon-containing carbon nanotubes in which carbon in a surface layer of unsubstituted carbon nanotubes is substituted with silicon. Thereby, the hydrogen radical resistance of the pellicle film can be improved, and an increase in the diameter of the carbon nanotubes can be suppressed, so that a favorable light transmittance (such as transmittance of EUV light) can be maintained.

The pellicle film of the disclosure is suitable for producing a pellicle for exposure light having a short wavelength (such as EUV light and light having a wavelength shorter than the wavelengths of EUV light).

Among the above, the pellicle film of the disclosure is suitably used for exposure using EUV light.

In the disclosure, extreme ultraviolet (EUV) light refers to light having a wavelength of from 1 nm to 100 nm.

The wavelength of EUV light is preferably from 5 nm to 13.5 nm.

In the disclosure, EUV light and light having a wavelength shorter than the wavelengths of EUV light are collectively referred to as "EUV light or the like" in some cases.

<Silicon-Containing Carbon Nanotube>

The silicon-containing carbon nanotubes of the disclosure are carbon nanotubes having a silicon carbide layer in which at least a part of carbon is substituted with silicon at least on a surface layer side.

Thereby, favorable hydrogen radical resistance can be imparted to the pellicle film containing carbon nanotubes.

The diameter of a tube in the silicon-containing carbon nanotubes can be, for example, from 0.8 nm to 400 nm.

From the viewpoint of suppressing breakage of the pellicle film, the tube diameter is preferably 2 nm or more, more preferably 4 nm or more, still more preferably 8 nm or more, very preferably 10 nm or more, particularly preferably 20 nm or more.

From the viewpoint of improving the light transmittance, the tube diameter is preferably 100 nm or less, more preferably 80 nm or less, still more preferably 60 nm or less, particularly preferably 40 nm or less.

The diameter of a tube in the carbon nanotubes refers to the diameter of a filament when present as a filament and refers to the diameter of a bundle when present as a bundle of carbon nanotubes (that is, a bundle) in the pellicle film.

The silicon-containing carbon nanotubes are not particularly limited and may be single-walled carbon nanotubes or multi-walled carbon nanotubes.

When the silicon-containing carbon nanotubes are single-walled carbon nanotubes, the thickness of a bundle in the single-walled carbon nanotubes may be, for example, from 4 nm to 400 nm.

From the viewpoint of suppressing breakage of the pellicle film, the thickness of the bundle is preferably 10 nm or more, more preferably 20 nm or more, still more preferably 40 nm or more, particularly preferably 50 nm or more.

From the viewpoint of improving the light transmittance, the thickness of the bundle is preferably 100 nm or less, more preferably 80 nm or less, still more preferably 60 nm or less, particularly preferably 40 nm or less.

When the silicon-containing carbon nanotubes are multi-walled carbon nanotubes,
the thickness of a filament of the multi-walled carbon nanotubes may be, for example, from 4 nm to 400 nm.

From the viewpoint of suppressing breakage of the pellicle film, the thickness of the bundle is preferably 10 nm or more, more preferably 20 nm or more, still more preferably 40 nm or more, particularly preferably 50 nm or more.

From the viewpoint of improving the light transmittance, the thickness of a filament of the multi-walled carbon nanotubes is preferably 100 nm or less, more preferably 80 nm or less, still more preferably 60 nm or less, particularly preferably 40 nm or less.

The silicon-containing carbon nanotubes of the disclosure are carbon nanotubes containing the silicon carbide layer at least on the surface layer side. The silicon-containing carbon nanotubes may be composed of only the silicon carbide layer or may further include a carbon nanotube layer as a layer other than the silicon carbide layer.

The carbon nanotube layer refers to a layer that does not contain silicon.

(Silicon Carbide Layer)

The silicon carbide layer is a layer in which at least a part of carbon is substituted with silicon. That is, the silicon carbide layer contains a -C-Si-C- bond formed by bonding silicon and carbon.

The silicon-containing carbon nanotubes of the disclosure contain the silicon carbide layer at least on the surface layer side.

The content of the silicon carbide layer is preferably in a range of from 10% by mass to 100% by mass with respect to the total mass of the carbon nanotubes.

When the content of the silicon carbide layer is 10% by mass or more with respect to the total mass of the carbon nanotubes, the hydrogen radical resistance of the pellicle film can be further improved.

From the above viewpoint, the content of the silicon carbide layer is more preferably 15% by mass or more, still more preferably 20% by mass or more, very preferably 30% by mass or more, particularly preferably 50% by mass or more, with respect to the total mass of the carbon nanotubes.

The upper limit of the content of the silicon carbide layer may be 100% by mass or less, but from the viewpoint of maintaining the strength of the pellicle film while maintaining the EUV transmittance, the content of the silicon carbide layer is preferably 90% by mass or less, more preferably 70% by mass or less, very preferably 50% by mass or less, particularly preferably 40% by mass or less, with respect to the total mass of the carbon nanotubes.

The content of the silicon carbide layer is measured using an X-ray photoelectron spectroscopy (XPS) apparatus (such as an Axis NOVA manufactured by Shimadzu Corporation).

First, the content of silicon is measured with an X-ray photoelectron spectroscopy (XPS) apparatus.

The content of the silicon carbide layer is obtained by converting the obtained content of silicon into the content of silicon carbide.

In the silicon carbide layer, substitution with elements other than silicon in the carbon nanotubes is possible as long as the effects of the disclosure are not impaired.

Examples of the other elements include boron and ruthenium.

(Carbon Nanotube Layer)

The silicon-containing carbon nanotubes of the disclosure may include the silicon carbide layer at least on the surface layer side and may further include a carbon nanotube layer on the inner side.

When the silicon-containing carbon nanotubes of the disclosure further include a carbon nanotube layer inside, the strength of the silicon-containing carbon nanotubes can be further improved, so that the strength of the pellicle film of the disclosure containing the silicon-containing carbon nanotubes can be further improved.

The carbon nanotube layer means a carbon nanotube layer containing no silicon.

The content of the carbon nanotube layer is preferably in a range of from more than 0% by mass to less than 90% by mass with respect to the total mass of the silicon-containing carbon nanotubes.

When the content of the carbon nanotube layer is more than 0% by mass with respect to the total mass of the carbon nanotubes, the strength of the pellicle film can be further improved.

From the above viewpoint, the content of the silicon carbide layer is more preferably 15% by mass or more, still more preferably 20% by mass or more, very preferably 30% by mass or more, particularly preferably 50% by mass or more, with respect to the total mass of the carbon nanotubes.

When the content of the carbon nanotube layer is less than 90% by mass, the content of the silicon carbide layer can be relatively improved, so that the hydrogen radical resistance of the pellicle film can be further improved.

From the above viewpoint, the content of the carbon nanotube layer is preferably 80% by mass or less, more preferably 70% by mass or less, with respect to the total mass of the carbon nanotubes.

The thickness ratio between the silicon carbide layer and the carbon nanotube layer (silicon carbide layer/carbon nanotube layer) is preferably 3/100 or more, more preferably 5/100 or more, still more preferably 10/100 or more, from the viewpoint of improving the hydrogen radical resistance of the pellicle film.

From the viewpoint of improving the strength of the pellicle film and the transmittance of EUV light, the thickness ratio between the silicon carbide layer and the carbon nanotube layer (silicon carbide layer/carbon nanotube layer) is preferably 60/100 or less, more preferably 30/100 or less, still more preferably 20/100 or less.

The thickness ratio between the silicon carbide layer and the carbon nanotube layer is measured using an X-ray photoelectron spectroscopy (XPS) apparatus (such as an Axis NOVA manufactured by Shimadzu Corporation).

<Antioxidizing Layer>

An antioxidizing layer may be disposed on at least one side of the pellicle film of the disclosure.

When the antioxidizing layer is disposed on the pellicle film, oxidation of the pellicle film is suppressed during light irradiation or pellicle storage.

The type of the antioxidizing layer is not particularly limited as long as the layer is made of a material stable to light (preferably EUV light). For example, the layer may be a layer made of $SiO_x$ ($x \le 2$), $Si_xN_y$ ($x/y$ is from 0.7 to 1.5), SiON, $Y_2O_3$, YN, Mo, Ru, Rb, Sr, Y, Zr, Nb, or Rh.

In order not to inhibit light transmission, the thickness of the antioxidizing layer is preferably from about 1 nm to 10 nm, more preferably from about 2 nm to 5 nm. By setting the thickness of the antioxidizing layer to from about 1 nm to 10 nm, light absorption by the antioxidizing layer can be suppressed, and a decrease in transmittance can be suppressed.

The ratio of the thickness of the antioxidizing layer to the thickness of the pellicle film is preferably in a range of from 0.03 to 1.0. Within the above numerical range, light absorption by the antioxidizing layer can be suppressed, and a decrease in transmittance can be suppressed.

In addition, when the antioxidizing layer is disposed on the pellicle film, light is reflected at a newly formed layer interface, that is, an interface between the antioxidizing layer and air and an interface between the antioxidizing layer and the pellicle film, and there is a possibility that the transmittance decreases. The light reflectance at the layer interfaces can be calculated according to the thicknesses of the pellicle film and the antioxidizing layer and the types of elements constituting the pellicle film and the antioxidizing layer. Then, by optimizing the thicknesses of the films in the same manner as the principle of an antireflection film, the reflectance can be reduced.

The thickness of the antioxidizing layer is preferably an optimum thickness within a range in which a decrease in light transmittance due to absorption and a decrease in light transmittance due to reflection are suppressed, and the antioxidizing layer has antioxidation performance.

Thickness uniformity and surface roughness of the antioxidizing layer are also not particularly limited. In a patterning step of exposure, the antioxidizing layer may be either a continuous layer or a sea-island shape as long as non-uniformity of the film thickness or non-uniformity of the transmittance derived from surface roughness, hindrance due to scattering of light, or the like does not occur, and the film thickness may be non-uniform or surface roughness may be present.

The average refractive index of the pellicle film including the pellicle film and the antioxidizing layer is preferably in a range of from 1.9 to 5.0. The refractive index can be measured by a method such as spectroscopic ellipsometry. In addition, the average density of the pellicle film including the pellicle film and the antioxidizing layer is preferably in a range of from 1.5 $g/cm^3$ to 5.0 $g/cm^3$. The density can be measured by a method such as an X-ray reflection method.

The thickness of the pellicle film (the total thickness in the case of two or more layers) can be, for example, from 2 nm to 200 nm.

From the viewpoint of increasing the transmittance of EUV light, the thickness of the pellicle film is preferably 100 nm or less, more preferably 50 nm or less, still more preferably 40 nm or less, very preferably 30 nm or less, particularly preferably 20 nm or less.

From the viewpoint of the ease of breakage of the pellicle film and the foreign matter shielding property (that is, from the viewpoint of preventing foreign matter from passing through the pellicle film), the thickness of the pellicle film is preferably 5 nm or more, more preferably 10 nm or more, still more preferably 20 nm or more.

In the pellicle film of the disclosure, the carbon nanotubes preferably form a nonwoven fabric shape.

Since the shape of the silicon-containing carbon nanotubes contained in the pellicle film of the disclosure is usually a fiber shape, a nonwoven fabric shape can be formed as the entire pellicle film of the disclosure.

Since the carbon nanotubes contained in the pellicle film form a nonwoven fabric shape, air permeability of the pellicle film can be secured.

For example, when exposure is performed using EUV light with an exposure device including a pellicle, it is required to irradiate the pellicle with EUV light under vacuum or reduced pressure conditions.

Usually, a vent hole is provided in the pellicle, and air inside the pellicle is removed from the vent hole to create a vacuum or depressurized environment, but there is a problem that it takes time and effort to provide the vent hole.

In the pellicle film of the disclosure, since the carbon nanotubes form a nonwoven fabric shape, air permeability can be secured by the nonwoven fabric shape, and a vacuum or reduced pressure environment can be easily created.

[Physical Properties of Pellicle Film]

(Heat Dissipation Property and Heat Resistance)

When, for example, EUV is used as light for exposure, energy of the EUV is changed to heat through various relaxation processes. Therefore, the pellicle film is required to have the heat dissipation property and heat resistance. A pellicle film including the film of the disclosure has both the heat dissipation property and heat resistance and is less likely to be damaged during EUV lithography.

Therefore, while a conventional pellicle film made of monocrystalline silicon has problems of having a low heat dissipation property and therefore being easily deformed or damaged due to thermal damage during EUV light irradiation, the original plate can be more reliably protected by using the pellicle film of the disclosure. The reason why a pellicle film (hereinafter also referred to as a "carbon-containing film") containing a carbon material has both the heat dissipation property and heat resistance will be described below.

The heat dissipation property of the carbon-containing film is mainly determined by (i) the emissivity of the carbon-containing film (release of energy in the form of infrared rays) and (ii) the thermal conductivity of the carbon-containing film.

(i) The following relational expression (1) is established between the emissivity $\varepsilon$ of the carbon-containing film, the temperature T of the carbon-containing film during the EUV light irradiation, the EUV light irradiation intensity P, the EUV transmittance Tr of the carbon-containing film, the Stefan-Boltzmann constant $\sigma$, and the wall temperature (temperature inside the EUV light irradiation device) Tw. In the relational expression (1), the thermal conductivity of the carbon-containing film is set to 0.
[Mathematical Formula 1]

$$T = \left( \frac{P \cdot (1 - Tr)}{\varepsilon \cdot \sigma} + T_W{}^4 \right)^{1/4} \quad \cdots (1)$$

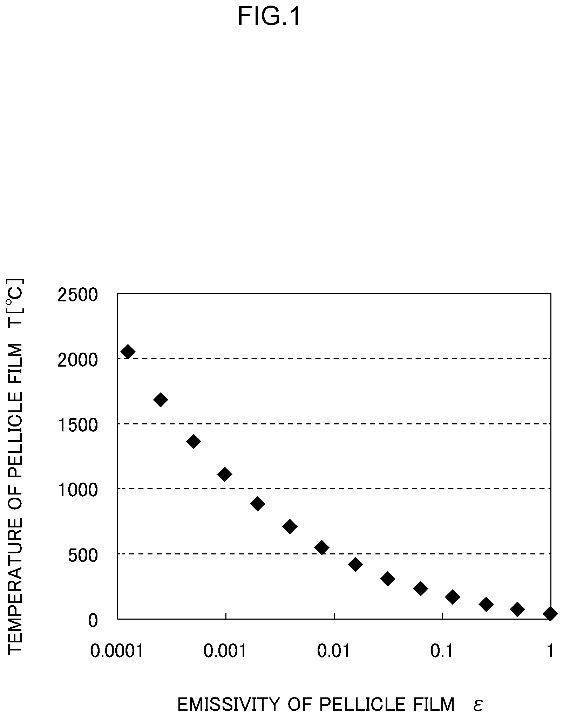

Fig. 1 is a graph showing the relationship between the "carbon-containing film temperature T" and the "emissivity ε of the carbon-containing film" obtained from the above formula (1). In this graph, the EUV transmittance Tr of the carbon-containing film is 80%, and the EUV light irradiation intensity P is 100 $W/cm^2$. As shown in Fig. 1, it is found that the temperature T of the carbon-containing film decreases as the emissivity ε of the carbon-containing film increases.

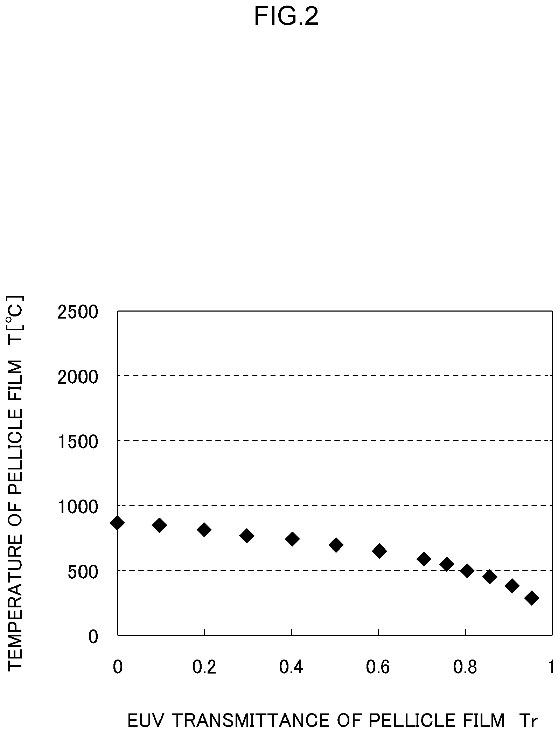

On the other hand, Fig. 2 is a graph showing the relationship between the "carbon-containing film temperature T" and the "transmittance Tr of the carbon-containing film" obtained from the above formula (1). In this graph, the emissivity ε of the carbon-containing film is 0.01, and the EUV light irradiation intensity P is 100 $W/cm^2$. As shown in Fig. 2, when the transmittance Tr of the carbon-containing film changes, the temperature T of the carbon-containing film slightly changes, but the amount of change is small. That is, the temperature T of the carbon-containing film hardly depends on the EUV transmittance Tr of the carbon-containing film but largely depends on the emissivity ε of the carbon-containing film.

Here, it is difficult to experimentally determine the emissivity ε of the carbon-containing film. However, according to Kirchhoff s law, the film having a higher infrared absorptivity has a higher emissivity ε. Therefore, the emissivity of the carbon-containing film is predicted to some extent from the far-infrared absorption spectrum of the pellicle film.

Infrared absorption of single crystal silicon, which is a conventional pellicle film, is only absorption attributable to a stretching vibration mode of a Si-Si bond and has a low infrared absorptivity. Therefore, the single-crystal silicon film has low emissivity.

On the other hand, the carbon material forming the carbon-containing film has absorption derived from a C-H bond and strong absorption derived from an $sp^2$ carbon bond and has a high infrared absorptivity. Therefore, the carbon-containing film has high emissivity.

(ii) The thermal conductivity of the pellicle film is determined by the thermal conductivity of the material forming the film. The thermal conductivity of the single crystal silicon is from 150 W/mK to 170 W/mK. On the other hand, a graphite film as an example of the carbon-containing film has a thermal conductivity of from 1,000 W/mK to 5,000 W/mK. That is, while a pellicle film made of single crystal silicon has low thermal conductivity, a carbon-containing film such as a graphite film has high thermal conductivity.

From the above, it can be seen that the single crystal silicon film, which is a conventional pellicle film, is inferior in both (i) emissivity and (ii) thermal conductivity and therefore has an insufficient heat dissipation property. On the other hand, the carbon-containing film of the disclosure is excellent in both (i) emissivity and (ii) thermal conductivity. Therefore, it can be said that the heat dissipation property is very high.

The heat resistance of the pellicle film is determined by the melting point of the material constituting the pellicle film. The melting point of the carbon-containing film such as graphite is 3,600°C, whereas the melting point of single crystal silicon is 1,410°C.

That is, a carbon-containing film such as a graphite film is remarkably excellent in heat resistance as compared with a conventional pellicle film made of single crystal silicon.

(EUV Transmittivity and Thickness of Pellicle Film)

In the pellicle film of the disclosure, the transmittance of light (such as light having a wavelength of 13.5 nm, light having a wavelength of 6.75 nm, and EUV) used for lithography is preferably 50% or more, more preferably 80% or more, still more preferably 90% or more, particularly preferably 92% or more. When the pellicle film is disposed on the antioxidizing layer, the light transmittance of the film containing these is preferably 50% or more, more preferably 70% or more, still more preferably 80% or more.

The light transmittance Tr of the pellicle film is measured with a photodiode. Specifically, the transmittance is obtained on the basis of the following formula (2) from a current value (incident light intensity $I_0$) detected in a state where the pellicle film is not installed and where a current value (transmitted light intensity I) detected in a state where the pellicle film is installed.

[Mathematical Formula 2]

$$Tr \equiv I/I_0 \cdots (2)$$

The thickness of the pellicle film is preferably set in consideration of the light transmittance of the pellicle film, the infrared absorptivity of the pellicle film, the strength of the pellicle film, and self-standing ability.

The thickness uniformity and surface roughness of the pellicle film are not particularly limited as long as the nonuniformity of the film thickness or the nonuniformity of the transmittance derived from the surface roughness, troubles caused by the scattering of the EUV light, and the like do not occur in the patterning process of the EUV exposure.

In the patterning step of the EUV exposure, the pellicle film may have wrinkles as long as there is no problem due to a decrease or nonuniformity in transmittance or scattering derived from the wrinkles.

The relationship of the following formula (3) is established between the EUV transmittance Tr of the pellicle film and the thickness d of the pellicle film.

[Mathematical Formula 3]

$$Tr = I/I_0 = \exp(-\mu\rho d) \cdots (3)$$

where I is the intensity of light transmitted through the pellicle film, $I_0$ is the intensity of incident light, d is the thickness of the pellicle film, $\rho$ is the density, and $\mu$ is the mass absorption coefficient of the pellicle film.

The density $\rho$ in the formula (3) is a density unique to a substance constituting the pellicle film. The mass absorption coefficient $\mu$ in the formula (3) above is obtained as follows. When the energy of a photon is more than about 30 eV and the energy of the photon is sufficiently different from the absorption edge of an atom, the mass absorption coefficient $\mu$ does not depend on the bonding state between atoms or the like. For example, the photon energy at a wavelength of 13.5 nm is around 92.5 eV and is sufficiently different from the absorption edge of the atom. Therefore, the mass absorption coefficient $\mu$ does not depend on the bonding state between atoms of the compound constituting the pellicle film. Therefore, the mass absorption coefficient $\mu$ of the pellicle film is obtained by the following formula (4) from the mass absorption coefficient $\mu_1$ of each element (1, 2,..., i) constituting the pellicle film and the mass fraction $W_i$ of each element.

[Mathematical Formula 4]

$$\mu = \mu_1 W_1 + \mu_2 W_2 + ... \mu_i W_i \cdots (4)$$

$W_i$ above is a value determined by $W_i = n_i A_i / \Sigma n_i A_i$, where $A_i$ is the atomic weight of each element i, and $n_i$ is the number of each element i.

As the mass absorption coefficient $\mu$ of each element in the above formula (4), values in the following reference summarized by Henke et al. can be applied (B. L. Henke, E. M. Gullikson, and J. C. Davis, "X-Ray Interactions: Photoabsorption, Scattering, Transmission, and Reflection at E = 50 - 30,000 eV, Z = 1 - 92," At. Data Nucl. Data Tables 54, 181 (1993), updated versions of these numbers are available at http://www.cxro.lbl.gov/optical_constants/).

That is, if the mass absorption coefficient $\mu$ of the pellicle film and the density $\rho$ of the film can be specified, a preferable thickness d of the pellicle film can be set on the basis of a desired EUV transmittance Tr.

(Stress of Pellicle Film)

Stress may remain in a pellicle film obtained by forming a thin film on a substrate such as a silicon wafer. When the residual stress of the pellicle film is large, cracks may be formed, or breakage may be caused when the pellicle film is made into a self-standing film. Therefore, the residual stress of the pellicle film is preferably small. The direction and magnitude of the residual stress of the pellicle film can be measured by measuring the direction and magnitude of the warpage of the substrate on which the film has been formed. The direction and magnitude of warpage of the substrate on which the film has been formed can be measured using, for example, a displacement measuring apparatus using a laser beam and specifically can be measured using a three-dimensional shape measuring apparatus (NH-3SP manufactured by Mitaka Kohki Co., Ltd.) or the like.

The magnitude of the residual stress of the pellicle film is preferably 1 GPa or less, more preferably 0.5 GPa or less, and still more preferably 0.2 GPa or less.

The residual stress is preferably stress in the tensile direction. When the direction of the residual stress is the tensile direction, tension is applied to the film, so that a self-standing film without wrinkles can be obtained. On the other hand, when the direction of the residual stress is the compression direction, a compressive force is applied to the film, so that wrinkles are formed. By reducing wrinkles of the film, a change in the thickness of the film can be suppressed to make the transmittance of EUV more uniform, and the film can be made less likely to be broken by an external force such as vibration.

<Pellicle>

A pellicle of the disclosure (hereinafter also simply referred to as a pellicle) includes the pellicle film of the disclosure and a support frame supporting the pellicle film.

Since the pellicle of the disclosure includes the pellicle film of the disclosure, the pellicle exhibits the same effect as that of the pellicle film of the disclosure.

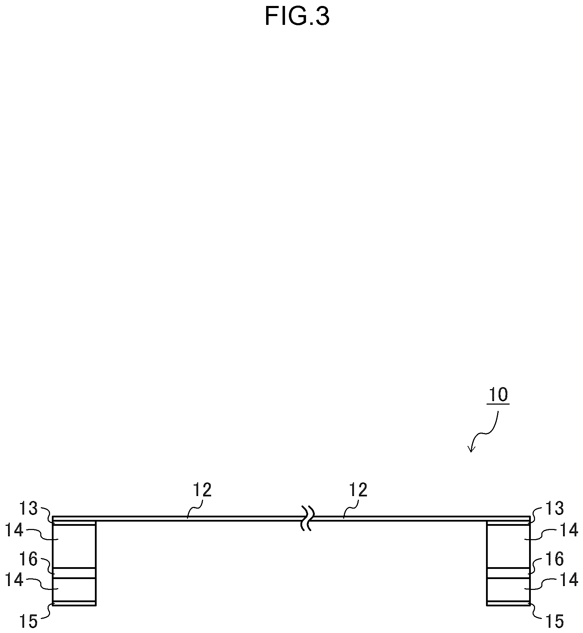

A pellicle according to the disclosure will be described below with reference to Fig. 3.

Fig. 3 is a schematic cross-sectional view of a pellicle 10 of the disclosure. The pellicle 10 is constituted by bonding a pellicle film 12 and a support frame 14 to each other with a film adhesive layer 13 interposed therebetween, and a vent hole 16 and an original plate adhesive layer 15 are formed in the support frame 14.

[Support Frame]

The support frame (pellicle frame) 14 is for supporting the pellicle film 12.

The material, shape, and the like of the support frame are not particularly limited as long as the frame can support the pellicle film of the disclosure with the film adhesive layer or the like interposed therebetween. The support frame may be, for example, a frame made of aluminum, stainless steel, a resin such as polyethylene, or a ceramic.

For example, as shown in Fig. 3, the support frame 14 may have a region surrounded by the pellicle 10 and an original plate (not shown) and the vent hole 16 for making the air pressure in the EUV exposure device constant. As described above, even when the vent hole 16 is not provided, it is possible to create a vacuum environment and a reduced pressure environment as long as the pellicle film of the disclosure has a nonwoven fabric shape.

Since the exposure with the EUV light is performed under a vacuum environment (reduced pressure environment), if the atmospheric pressure at the time of exposure is nonuniform, the pellicle film 12 may expand and contract or be damaged by a pressure difference. A filter is preferably disposed in the vent hole 16 so that foreign matter does not enter a region surrounded by the pellicle 10 and the original plate.

Examples of the filter include an ultra-low penetration air (ULPA) filter and a metal mesh. The support frame 14 may be colored within a range that does not interfere with exposure for easy inspection.

The procedure and method of fixing the pellicle film to the support frame are not particularly limited. An etched substrate may be used as a part of the support frame. For example, the pellicle film may be disposed on a substrate such as a metal, a silicon wafer, glass, a resin, and a salt that can be removed by a specific processing method, a mask may be applied thereafter to the substrate surface opposite to the surface on which the pellicle film has been disposed in accordance with the size of the frame, and etching or dissolution may be performed while leaving the mask shape. Thereby, a pellicle using a part of the substrate as the support frame can be obtained.

A trimming method of matching the shape of the substrate with the frame shape is not particularly limited. When a silicon wafer is used, a method of mechanically breaking the wafer or a method of laser trimming can be used.

[Film Adhesive Layer]

The film adhesive layer 13 is a layer that bonds the support frame 14 and the pellicle film 12. The film adhesive layer 13 can be a layer made of, for example, an acrylic resin adhesive, an epoxy resin adhesive, a polyimide resin adhesive, a silicone resin adhesive, an inorganic adhesive, or the like. From the viewpoint of maintaining the degree of vacuum at the time of EUV exposure, the film adhesive layer 13 preferably shows less outgassing. As a method of evaluating outgassing, for example, a thermal desorption spectrometer can be used.

In addition, the method of fixing the pellicle film to the support frame is not particularly limited, and the pellicle film may be directly attached to the support frame, the film adhesive layer on one end surface of the support frame may be interposed, or the pellicle film and the support frame may be fixed by a mechanical fixing method or using an attractive force of a magnet or the like.

As a method of evaluating the adhesiveness between the pellicle film and the support frame, for example, a method of evaluating the presence or absence of breakage or peeling of the film by air blowing while changing the pressure, area, distance, and angle, a method of evaluating the presence or absence of breakage or peeling of the film by a vibration test while changing the acceleration and amplitude, or the like can be used.

[Original Plate Adhesive Layer]

The original plate adhesive layer 15 is a layer that bonds the support frame 14 and the original plate. As shown in Fig. 3, the original plate adhesive layer 15 is provided at an end portion of the support frame 14 on a side where the pellicle film 12 is not fixed. The original plate adhesive layer 15 is, for example, a double-sided adhesive tape, a silicone resin adhesive, an acrylic adhesive, a polyolefin adhesive, an inorganic adhesive, or the like. From the viewpoint of maintaining the degree of vacuum at the time of EUV exposure, the original plate adhesive layer 15 preferably shows less outgassing. As a method of evaluating outgassing, for example, a thermal desorption spectrometer can be used.

The film adhesive layer 13 and the original plate adhesive layer 15 are preferably EUV resistant because the layers are exposed to EUV light scattered in an EUV exposure device. When the EUV resistance is low, adhesiveness and strength of the adhesive are reduced during EUV exposure, and defects such as peeling of the adhesive and generation of foreign matter occur in the exposure device. For the resistance evaluation by EUV light irradiation, for example, methods of composition analysis such as XPS measurement, EDS analysis, and RBS, methods of structural analysis such as XPS, EELS, IR measurement, and Raman spectroscopy, film thickness evaluation methods such as ellipsometry, interference spectroscopy, and X-ray reflection, appearance and surface shape evaluation methods such as microscopic observation, SEM observation, and AFM observation, and strength and adhesiveness evaluation methods with nanoindenter and by peeling test can be used.

In lithography, it is necessary for a circuit pattern to be accurately transferred. Therefore, it is necessary that the transmittance of the exposure light is substantially uniform in the exposure range. By using the pellicle film 12 of the disclosure, the pellicle 10 having a uniform light transmittance in an exposure range is obtained.

(Use of Pellicle)

The pellicle of the disclosure may be used not only as a protective member for suppressing adhesion of foreign matter to an original plate in an EUV exposure device but also as a protective member for protecting the original plate during storage of the original plate or transportation of the original plate. For example, if the pellicle is attached to the original plate (original plate for exposure), storing as it is after being removed from the EUV exposure device is possible. Examples of the method of attaching the pellicle to the original plate include a method of bonding the pellicle with an adhesive, an electrostatic adsorption method, and a method of mechanically fixing the pellicle.

[Modification]

As a modification of the pellicle 20 of the disclosure, a pellicle film constituting a pellicle may be provided with antioxidizing layers disposed on both surfaces of the film.

When the antioxidizing layers are disposed on the pellicle film, oxidation of the pellicle film is suppressed during EUV light irradiation or pellicle storage. The antioxidizing layer may be disposed only on one side of the pellicle film.

«Method of Producing Pellicle»

A method of producing a pellicle includes preparing a carbon nanotube (preparation step), forming the carbon nanotube into a sheet shape to produce a carbon nanotube sheet (sheet producing step), connecting the carbon nanotube sheet to a support frame having an opening so as to cover the opening to produce a pellicle precursor (precursor producing step), and disposing the pellicle precursor and a Si-containing particle in a chamber and heating the chamber at a heating temperature of from 1,000°C to 1,700°C for a heating time of from 5 minutes to 120 minutes (heating step).

<Preparation Step>

The preparation step is a step of preparing carbon nanotubes.

The silicon-containing carbon nanotubes contained in the pellicle of the disclosure can be produced by preparing carbon nanotubes and substituting silicon for carbon in the surface layer of the carbon nanotubes (hereinafter also referred to as silicidation).

That is, in the preparation step, carbon nanotubes to be silicided later are prepared.

As the carbon nanotubes to be silicided (which may be carbon nanotube bulk structures), those formed on a substrate for chemical vapor deposition by a chemical vapor deposition (CVD) method in which a metal catalyst is present in a reaction system and an oxidizing agent is added to a reaction atmosphere are preferably used.

As the CVD method, for example, a plasma CVD method is used, but a low-pressure CVD method or a thermal CVD method may be used.

At this time, water vapor is used as the oxidant. The concentration of water vapor may be from 10 ppm to 10,000 ppm, and water vapor may be added under a temperature environment of from 600°C to 1,000°C.

In addition, carbon nanotubes may be synthesized by disposing or patterning a metal catalyst on a substrate for chemical vapor deposition.

The resulting carbon nanotubes may be single-walled or multi-walled carbon nanotubes or may be carbon nanotubes erected in a direction perpendicular to the surface of the substrate for chemical vapor deposition.

Specifically, it can be produced with reference to, for example, WO 2006/011655 A.

Examples of commercially available products of such carbon nanotubes include carbon nanotubes produced by the super-growth method sold by Zeon Corporation.

As the carbon nanotubes to be silicided (which may be carbon nanotube bulk structures), those produced by the enhanced direct injection pyrolytic synthesis (hereinafter referred to as the e-DIPS method) method are preferably used.

The direct injection pyrolytic synthesis method (hereinafter referred to as the DIPS method) is a gas phase flow method in which a hydrocarbon-based solution containing a catalyst (or a catalyst precursor) and a reaction accelerator is atomized by spraying and introduced into a high-temperature heating furnace to synthesize single-walled carbon nanotubes in a flowing gas phase.

The e-DIPS method obtained by improving the DIPS method focuses on a particle formation process in which ferrocene used in a catalyst has a different particle diameter on the upstream and downstream sides in a reaction furnace, and decomposition is relatively easy in a carrier gas unlike the DIPS method in which only an organic solvent is used as a carbon source. That is, the method is a method in which the growth point of single-walled carbon nanotubes is controlled by mixing a second carbon source that is likely to be a carbon source.

In particular, the carbon nanotubes can be produced with reference to Saito et al., J. Nanosci. Nanotechnol., 8 (2008) 6153-6157.

Examples of a commercially available product of such carbon nanotubes include trade name "MEIJO eDIPS" manufactured by Meijo Nano Carbon Co., Ltd.

<Sheet Producing Step>

The sheet producing step is a step of forming carbon nanotubes into a sheet shape to produce a carbon nanotube sheet.

The method of forming carbon nanotubes into a sheet shape is not particularly limited, and for example, a method of forming carbon nanotubes into a sheet shape on a substrate may be used.

Carbon nanotubes (or carbon nanotube bulk structures) obtained by the CVD method, the e-DIPS method, or the like can be used in a state of being dispersed in a solvent.

A liquid (dispersion liquid) in which carbon nanotubes (or carbon nanotube bulk structures) are dispersed is applied onto a substrate, and the solvent is evaporated and removed to form a carbon nanotube film on the substrate.

In the case of a book, by removing the solvent used for the dispersion liquid, a film in which the carbon nanotubes are substantially parallel to the surface of a substrate 110 is obtained.

The application method is not particularly limited, and for example, spin coating, dip coating, bar coating, spray coating, electrospray coating, or the like may be used.

Incidentally, a metal catalyst used for carbon nanotube formation may cause a decrease in EUV transmittance, but when the carbon nanotubes are peeled off from the substrate for chemical vapor deposition, there is no influence because the carbon nanotubes contain almost no metal catalyst.

As the substrate, an inorganic material may be used.

For example, silicon (Si) may be used for the substrate. Note that the substrate is not limited to silicon (Si) but may be a semiconductor material such as germanium (Ge), silicon germanium (SiGe), silicon carbide (SiC), and gallium arsenide (GaAs), a glass substrate such as a quartz glass substrate (silicon oxide ($SiO_2$)), a soda glass substrate, a borosilicate glass substrate, and a sapphire substrate, a silicon nitride (SiN), an aluminum nitride (AlN) substrate, a zirconia ($ZrO_2$) substrate, an aluminum oxide ($Al_2O_3$), or the like.

In addition, from the viewpoint of reducing thermal strain with the carbon nanotube film, the substrate preferably contains at least one of silicon, sapphire, or silicon carbide having a linear thermal expansion coefficient close to that of the pellicle film.

Silicon (Si) may be any of single crystal silicon, polycrystalline silicon, microcrystalline silicon, and amorphous silicon but is preferably single crystal silicon from the viewpoint of etching efficiency and the viewpoint of high versatility and low cost.

The shape of the substrate may be circular or rectangular.

The thickness of the substrate is not particularly limited but is preferably from 100 $\mu$m to 1,000 $\mu$m, preferably from 200 $\mu$m to 1,000 $\mu$m from the viewpoint of handling.

<Precursor Producing Step>

The precursor producing step is a step of producing a pellicle precursor by connecting the carbon nanotube sheet to the support frame so as to cover the opening of the support frame having the opening.

In the precursor producing step, after the carbon nanotube sheet and the substrate are separated, the separated carbon nanotube sheet may be connected to the support frame (that is, the pellicle frame) to produce the pellicle precursor.

The method of producing a pellicle precursor by separating the carbon nanotube sheet and the substrate is not particularly limited, and examples of the method include the following production examples.

(Method of Laminating Sacrificial Layer on Substrate and Then Removing Sacrificial Layer)

A self-standing film can be obtained by disposing a sacrificial layer on a substrate, forming a carbon nanotube sheet thereon, and then removing the sacrificial layer.

The sacrificial layer can be a metal, an oxide film, a resin, a salt, or the like that can be removed by a specific treatment method. For example, the sacrificial layer may be a metal such as aluminum that is soluble in an acidic solution. Specifically, the film can be peeled off from the substrate by disposing a metal layer on the surface of a glass substrate or a silicon wafer by vapor deposition, sputtering, or the like, further disposing a carbon nanotube sheet on the metal layer, and then immersing the product in a solution capable of dissolving the metal layer, such as an acidic solution.

When a silicon wafer provided with a natural oxide film or a silicon oxide layer is used as the substrate, the natural oxide film or the silicon oxide layer on the silicon wafer is coated with the carbon nanotube sheet, and then the product is immersed in a hydrofluoric acid aqueous solution to remove the natural oxide film or the silicon oxide layer, so that the carbon nanotube sheet can be peeled off from the substrate.

The sacrificial layer to be disposed on the substrate may be a water-soluble material such as a partially saponified polyvinyl alcohol resin or a salt such as sodium chloride. The film can be peeled off from the substrate by disposing the carbon nanotube sheet on the sacrificial layer and then immersing the laminate in water.

In selecting a method of removing the sacrificial layer disposed on the substrate, the most appropriate arbitrary method can be selected according to characteristics such as process resistance of the carbon nanotube sheet, film strength, removal speed of the sacrificial layer, and film thickness uniformity and surface roughness of the sacrificial layer.

(Method of Etching or Dissolving Substrate)

In a case in which the material of the substrate is a metal, an oxide film, a resin, a salt, or the like, which can be removed by a specific treatment method, a film can be obtained by disposing a carbon nanotube sheet on the substrate and then etching or dissolving the substrate.

For example, in a case in which a copper foil is used as the substrate, a carbon nanotube sheet is disposed on a surface of the copper foil, and then the product is immersed in a cupric chloride etching solution to etch the copper foil substrate and remove the substrate, whereby a film can be obtained.

When the substrate is a glass substrate, a carbon nanotube sheet is disposed on the glass substrate, and then the glass substrate is etched using hydrofluoric acid to remove the substrate, so that a film can be obtained.

When the substrate is a silicon wafer, after a carbon nanotube sheet is disposed on the silicon wafer, the silicon wafer is etched by wet etching or dry etching to remove the silicon wafer, so that a film can be obtained.

For the wet etching, an etching solution such as KOH, TMAH, or hydrazine can be used. For the dry etching, an etching gas such as a fluorine-based etching gas ($SF_6$, $CF_4$, $NF_3$, PFs, $BF_3$, $CHF_3$, $XeF_2$, or $F_2$+NO), a chlorine-based etching gas ($Cl_2$ or $SiCl_4$), or a bromine-based etching gas (IBr) can be used. Since the wet etching rate varies depending on the temperature, it is preferable to lower the liquid temperature and lower the etching rate in order to perform etching while preventing damaging the thin film containing carbon nanotubes on the silicon wafer.

When the silicon wafer is to be dry-etched, a layer such as an etching stop layer may be provided on the silicon substrate surface in advance.

Examples of the etching stop layer include a layer made of $SiO_2$ or SiN. The etching stop layer is preferably formed of a film that generates a tensile stress.

The residual stress acting in a direction parallel to the surfaces of the substrate and the thin film includes a tensile stress and a compressive stress. When a force for expanding the thin film acts on the inside of the thin film, the tensile stress is generated. On the other hand, when a force for contracting the thin film acts on the inside of the thin film, the compressive stress is generated. These stresses are mainly generated in the process of forming the thin film.

One of the factors causing residual stress is a difference in thermal expansion coefficient between the substrate and the thin film. When the temperature is returned to room temperature, both the substrate and the thin film contract, but the ratio of contraction varies depending on the thermal expansion coefficient. When the thermal expansion coefficient of the thin film is larger than the thermal expansion coefficient of the substrate, tensile stress is applied, and in the reverse case, compressive stress is applied. The film that generates tensile stress is preferable because tension is applied to the carbon nanotube sheet provided on the film to form a film without wrinkles. Since the layer made of SiN generates tensile stress, the carbon nanotube sheet obtained by dry-etching the silicon wafer can be a film without wrinkles. The etching stop layer is removed after the dry etching of the silicon wafer is completed, so that an intended self-standing film can be obtained.

When the substrate is a substrate made of a salt such as sodium chloride, a carbon nanotube sheet is disposed on a surface of the substrate, and then the substrate is etched by immersing the product in water to remove the substrate, so that a film can be obtained.

When the substrate is a plastic substrate, a carbon nanotube sheet is disposed on a surface of the plastic substrate, and then the product is immersed in a solvent that can dissolve the plastic substrate, so that the plastic substrate can be dissolved to obtain a film.

(Method of Performing Pretreatment to Easily Peel Surface of Substrate)

By subjecting the substrate to surface treatment, the interaction between the carbon nanotube sheet and the substrate surface can be controlled, and the film can be easily peeled from the substrate by immersion in a solvent or a mechanical peeling process.

Examples of a method of controlling the interaction between the carbon nanotube sheet and the substrate surface include a surface treatment method using a silane coupling agent. Other examples of the method include a method of washing the substrate surface with water, an organic solvent, piranha solution, sulfuric acid, UV ozone treatment, or the like.

When the substrate is a silicon wafer, a solution used in the RCA cleaning method, such as a mixed solution of a hydrogen peroxide solution and ammonium hydroxide and a mixed solution of hydrochloric acid and a hydrogen peroxide solution, can be used.

In the formation of the sacrificial layer and the surface treatment on the substrate, a method of etching or dissolving the substrate may be used in combination. The substance used for formation of the sacrificial layer or the surface treatment is preferably one that is less likely to remain on the surface, the inside, or the like of the carbon nanotube sheet and can be removed by an easy method even if remaining.

For example, there are etching with gas, evaporation by heat, washing with a solvent, decomposition removal by light, and the like, and these may be combined to perform removal.

<Heating Step>

The heating step is a step of disposing the pellicle precursor and Si-containing particles in a chamber and heating the inside of the chamber by evacuation at a degree of vacuum of 0.3 Pa for a peak heating time of from 5 minutes to 120 minutes at a heating temperature of from 1,200°C to 1,700°C.

In the heating step, carbon in the surface layer of the carbon nanotubes contained in the pellicle precursor is allowed to react with silicon in the Si-containing particles, so that the carbon is substituted with the silicon.

Examples of the Si-containing particles include particles of SiO and Si whose surface is naturally oxidized.

In the heating step, the heating time is from 5 minutes to 120 minutes.

From the viewpoint of achieving both excellent hydrogen radical resistance and light transmittance by adjusting the thickness of the silicon carbide layer, the heating time is preferably from 5 minutes to 60 minutes, more preferably from 10 minutes to 40 minutes.

In the heating step, the heating temperature is from 1,000°C to 1,700°C.

From the viewpoint of achieving both excellent hydrogen radical resistance and light transmittance by adjusting the thickness of the silicon carbide layer, the heating temperature is preferably from 1,250°C to 1,500°C, more preferably from 1,250°C to 1,400°C.

The method of producing a pellicle may include a step of performing substitution with an element other than silicon in the carbon nanotubes as long as the effect of the disclosure is not impaired.

<Original Plate for Exposure>

The original plate for exposure of the disclosure includes an original plate having a pattern and the pellicle of the disclosure attached to a surface of the original plate on a side having the pattern.

Since the original plate for exposure of the disclosure includes the pellicle of the disclosure, the original plate exhibits the same effect as that of the pellicle of the disclosure.

The method of attaching the original plate to the pellicle of the disclosure is not particularly limited. For example, the original plate may be directly attached to the support frame, the original plate adhesive layer on one end surface of the support frame may be interposed, or the original plate and the support frame may be fixed by a mechanical fixing method or using an attractive force of a magnet or the like.

Here, as the original plate, an original plate including a support substrate, a reflective layer disposed on the support substrate, and an absorber layer formed on the reflective layer can be used. When the absorber layer partially absorbs light (such as EUV light), a desired image is formed on a sensitive substrate (such as a semiconductor substrate with a photoresist film). The reflection layer may be a multilayer film of molybdenum (Mo) and silicon (Si). The absorber layer may be a material having a high absorptive property of EUV light or the like, such as chromium (Cr) or tantalum nitride.

<Exposure Device>

An exposure device of the disclosure includes a light source configured to emit exposure light, the original plate for exposure of the disclosure, and an optical system configured to guide the exposure light emitted from the light source to the original plate for exposure, in which the original plate for exposure is disposed such that the exposure light emitted from the light source passes through the pellicle film and is applied to the original plate.

Therefore, the exposure device of the disclosure has the same effect as that of the original plate for exposure of the disclosure.

The exposure device of the disclosure preferably includes a light source configured to emit exposure light (preferably EUV light or the like, more preferably EUV light. The same applies hereinafter), the original plate for exposure of the disclosure, and an optical system configured to guide the exposure light emitted from the light source to the original plate for exposure, in which the original plate for exposure is disposed such that the exposure light emitted from the light source passes through the pellicle film and is applied to the original plate.

With this aspect, it is possible to form a miniaturized pattern (for example, with a line width of 32 nm or less) with EUV light or the like and also to perform pattern exposure in which resolution failure due to foreign matter is reduced even when EUV light with which resolution failure due to foreign matter tends to be a problem is used.

<Method of Producing Semiconductor Device>

A method of producing a semiconductor device of the disclosure includes allowing exposure light emitted from a light source to pass through the pellicle film of the original plate for exposure of the disclosure, to be applied to the original plate, and to be reflected by the original plate, and allowing the exposure light reflected by the original plate to pass through the pellicle film and to be applied to a sensitive substrate to expose the sensitive substrate in a pattern.

According to the method of producing a semiconductor device of the disclosure, it is possible to produce a semiconductor device in which a resolution failure due to foreign matter is reduced even in the case of using EUV light with which a resolution failure due to foreign matter is likely to be a problem.

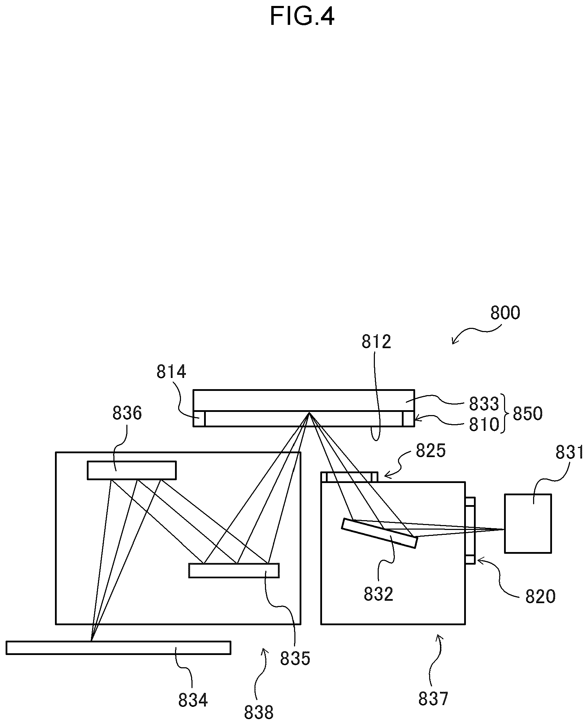

An example of a method of producing a semiconductor device according to the disclosure will be described below with reference to Fig. 4.

Fig. 4 is a schematic cross-sectional view of an EUV exposure device 800, which is an example of the exposure device of the disclosure.

As shown in Fig. 4, the EUV exposure device 800 includes a light source 831 that emits EUV light, an original plate 850 for exposure that is an example of the original plate for exposure of the disclosure, and an illumination optical system 837 that guides the EUV light emitted from the light source 831 to the original plate 850 for exposure.

The original plate 850 for exposure includes a pellicle 810 including a pellicle film 812 and a support frame 814, and an original plate 833. The original plate 850 for exposure is disposed such that the EUV light emitted from the light source 831 passes through the pellicle film 812 and is applied to the original plate 833.

The original plate 833 reflects the applied EUV light in a pattern.

The support frame 814 and the pellicle 810 are examples of the support frame and the pellicle of the disclosure, respectively.

In the EUV exposure device 800, filter windows 820 and 825 are installed between the light source 831 and the illumination optical system 837 and between the illumination optical system 837 and the original plate 833, respectively.

In addition, the EUV exposure device 800 includes a projection optical system 838 that guides the EUV light reflected by the original plate 833 to the sensitive substrate 834.

In the EUV exposure device 800, the EUV light reflected by the original plate 833 is guided onto the sensitive substrate 834 through the projection optical system 838, and the sensitive substrate 834 is exposed in a pattern. Exposure by EUV is performed under a reduced pressure condition.

The EUV light source 831 emits EUV light toward the illumination optical system 837.

The EUV light source 831 includes a target material, a pulse laser irradiation unit, and the like. EUV is obtained by irradiating the target material with pulsed laser light to generate plasma. When the target material is Sn, EUV having a wavelength of from 13 nm to 14 nm is obtained. The wavelength of the light emitted from the EUV light source is not limited to from 13 nm to 14 nm but may be light having a wavelength suitable for a purpose within a wavelength range of from 5 nm to 30 nm.

The illumination optical system 837 collects the light emitted from the EUV light source 831, uniformizes the illuminance, and irradiates the original plate 833 with the light.

The illumination optical system 837 includes plural multilayer film mirrors 832 for adjusting an optical path of EUV, an optical coupler (optical integrator), and the like. The multilayer film mirrors are multilayer films or the like in which molybdenum (Mo) and silicon (Si) are alternately layered.

The method of attaching the filter windows 820 and 825 is not particularly limited, and examples of the method include a method of attaching the filter windows via an adhesive or the like and a method of mechanically fixing the filter windows in the EUV exposure device.

The filter window 820 disposed between the light source 831 and the illumination optical system 837 captures scattered particles (debris) generated from the light source and prevents the scattered particles (debris) from adhering to an element (such as the multilayer film mirror 832) inside the illumination optical system 837.

On the other hand, the filter window 825 disposed between the illumination optical system 837 and the original plate 833 captures particles (debris) scattered from the light source 831 side and prevents the scattered particles (debris) from adhering to the original plate 833.

In addition, since the foreign matter attached to the original plate absorbs or scatters the EUV light, resolution failure to the wafer occurs. Therefore, the pellicle 810 is attached so as to cover the EUV light irradiation area of the original plate 833. The EUV light passes through the pellicle film 812 and is applied to the original plate 833.

The EUV light reflected by the original plate 833 passes through the pellicle film 812 and is applied to the sensitive substrate 834 through the projection optical system 838.

The projection optical system 838 condenses the light reflected by the original plate 833 and applies the light to the sensitive substrate 834. The projection optical system 838 includes plural multilayer film mirrors 835, 836, and the like for preparing an optical path of EUV.

The sensitive substrate 834 is a substrate or the like in which a resist is applied on a semiconductor wafer, and the resist is cured in a pattern with EUV reflected by the original plate 833. By developing this resist and etching the semiconductor wafer, a desired pattern is formed on the semiconductor wafer.

The pellicle 810 is attached to the original plate 833 with the original plate adhesive layer or the like interposed therebetween. Since the foreign matter attached to the original plate absorbs or scatters EUV, resolution failure to the wafer occurs. Therefore, the pellicle 810 is mounted so as to cover the EUV light irradiation area of the original plate 833, and the EUV passes through the pellicle film 812 and is applied to the original plate 833.

The method of attaching the pellicle 810 to the original plate 833 may be any method as long as the pellicle 810 can be installed on the original plate so that foreign matter does not adhere to the surface of the original plate, and examples of the method include a method in which the support frame 814 and the original plate 833 are bonded with an adhesive, an electrostatic adsorption method, a method in which the pellicle 810 is mechanically fixed, and the like but are not particularly limited. A method of bonding with an adhesive is preferably used.

Examples

The disclosure will be described below in more detail with reference to examples and the like, but the invention of the disclosure is not limited only to these examples.

The content of the silicon carbide layer was measured by the above-described method.

(Example 1)

Single-walled carbon nanotubes (also referred to as SWCNTs, manufactured by Meijo Nano Carbon Co., Ltd.) dispersed in a solvent were spin-coated on a Si substrate and dried to form an ultrathin film (hereinafter also referred to as a carbon nanotube film) of carbon nanotubes on the Si substrate.

Next, the Si substrate was gently immersed in a weakly alkaline water tank to dissolve the surface of the Si substrate, and the carbon nanotube film was separated as a single film from the Si substrate and floated on the water surface.

Subsequently, a stainless steel frame member having an opening was once immersed in the water tank, the carbon nanotube film was placed on the frame member, and then the frame member was slowly pulled up to stretch the carbon nanotube film as a self-standing film on the frame member.

When this carbon nanotube film was observed with a SEM, the carbon nanotubes had what is called a bundle structure, and bundles of from about 10 to 20 carbon nanotubes (that is, bundles) were entangled in a network. The thickness of the bundle was from 10 nm to 40 nm.

The carbon nanotube film stretched on the frame member was connected to the support frame so as to cover the opening of the support frame (pellicle frame) having the opening to provide a pellicle precursor. That is, the pellicle precursor includes the support frame and the carbon nanotube film stretched over the support frame.

The carbon nanotube film in the pellicle precursor was well dried, and the pellicle precursor was placed in a reaction furnace. In addition, a crucible containing SiO powder was provided, and the crucible was also placed in the reaction furnace.

Thereafter, the temperature of the reaction furnace was raised in vacuum, and SiO gas was generated when the temperature exceeded 800°C, and the carbon nanotubes were converted into SiC by holding for 10 minutes when the temperature reached 1300°C, thereby obtaining a carbon nanotube film (that is, a pellicle film (the thickness of the entire film: from 10 to 40 nm)) containing a silicon carbide layer (thickness of 3 nm, 15% by mass) and a pellicle.

The pellicle includes the pellicle film and the support frame connected to the pellicle film.

(Example 2)

A pellicle film (the thickness of the entire film: 80 nm) containing a silicon carbide layer (thickness of 10 nm, 12.5% by mass) and a pellicle were obtained in the same manner as in Example 1 except that the carbon nanotubes were changed from SWCNTs to multi-walled carbon nanotubes (MWCNTs, MW-1, manufactured by Meijo Nano Carbon Co., Ltd.) and that the retention time at the stage when the temperature of the reaction furnace reached 1300°C was changed as shown in Table 1.

In the film formed in Example 2, the carbon nanotubes as filaments formed a film. The carbon nanotubes had a thickness of from 10 nm to 40 nm.

(Comparative Example 1)

A pellicle film (thickness of the entire film: from 10 to 40 nm) and a pellicle were obtained in the same manner as in Example 1 except that the step of raising the temperature of the reaction furnace containing the pellicle precursor and the crucible containing the SiO powder to convert the carbon nanotube film contained in the pellicle precursor into SiC was not performed.

(Comparative Example 2)

A pellicle film (thickness of the entire film: 80 nm) and a pellicle were obtained in the same manner as in Example 2 except that the step of raising the temperature of the reaction furnace containing the pellicle precursor and the crucible containing the SiO powder to convert the carbon nanotube film contained in the pellicle precursor into SiC was not performed.

(Comparative Example 3)

SiC was coated on the carbon nanotube film in the pellicle precursor obtained in Example 1 by sputtering to obtain a pellicle film (thickness of the entire film: 23 nm) and a pellicle in the same manner as in Example 1.

The pellicle film in Comparative Example 3 is a pellicle film including a silicon carbide (SiC) coating layer on the carbon nanotube film. In addition, the content of the silicon carbide coating layer with respect to the total mass (that is, the total mass of the carbon nanotube film and the silicon carbide coating layer) of the pellicle film is shown in Table 1.

<Evaluation>

(Hydrogen Radical Resistance)

Hydrogen radical resistance of the pellicle films obtained in examples and comparative examples was evaluated by the following method.

A tungsten filament was placed on the windward side of a glass reaction furnace, hydrogen gas was radicalized, a sample was placed on the windward side, and the film thickness reduction rate of carbon nanotubes was measured and used as an index of hydrogen radical resistance. The results are shown in Table 1.

The smaller the film thickness reduction rate is, the more excellent hydrogen radical resistance is.

<Light Transmittance (EUV Transmittance)>

The pellicle film obtained in each of the examples and comparative examples was irradiated with EUV light having an intensity of 150 mW/cm$^2$, and light transmittance (EUV transmittance) was measured and evaluated according to the following evaluation criteria. The results are shown in Table 1.

-Evaluation Criteria-

A: EUV transmittance was 92% or more.
B: EUV transmittance was less than 92%.

[Table 1]

| | Conversion of surface layer into SiC | | Film thickness reduction rate | Content of silicon carbide layer (%) | Content of silicon carbide coating layer (%) | EUV transmittance (%) |
|---|---|---|---|---|---|---|
| | Temperature (°C) | Time (minute) | | | | |
| Example 1 | 1300 | 10 | Less than 5% | 15 | - | A |
| Example 2 | 1300 | 30 | Less than 5% | 12.5 | - | A |
| Comparative Example 1 | - | - | 100% | - | - | - |
| Comparative Example 2 | - | - | 100% | - | - | - |
| Comparative Example 3 | - | - | Less than 5% | - | 13 | B |

As shown in Table 1, Example 1 and Example 2 containing silicon-containing carbon nanotubes were excellent in hydrogen radical resistance due to a small decrease in film thickness and were also excellent in EUV transmittance.
On the other hand, in Comparative Example 1 and Comparative Example 2 in which the carbon nanotubes not containing silicon were used, the film thickness reduction was large, and the hydrogen radical resistance was poor.
The disclosure of Japanese Patent Application No. 2020-030942 filed on February 26, 2020 is incorporated herein by reference in its entirety.
All documents, patent applications, and technical standards described in the present specification are incorporated herein by reference to the same extent as if each document, patent application, and technical standard were specifically and individually indicated to be incorporated by reference.

**Claims**

1. A pellicle film comprising carbon nanotubes having a silicon carbide layer in which at least a part of carbon is substituted with silicon at least on a surface layer side.

2. The pellicle film according to claim 1, wherein a content of the silicon carbide layer is in a range of from 10% by mass to 100% by mass with respect to a total mass of the carbon nanotubes.

3. The pellicle film according to claim 1 or 2, wherein the film has a thickness of from 2 nm to 200 nm.

4. The pellicle film according to any one of claims 1 to 3, wherein a diameter of a tube in the carbon nanotubes is from 0.8 nm to 400 nm.

5. The pellicle film according to any one of claims 1 to 4, wherein the carbon nanotubes are single-walled carbon nanotubes or multi-walled carbon nanotubes.

6. The pellicle film according to claim 5, wherein a thickness of a bundle in the single-walled carbon nanotubes is from 4 nm to 400 nm.

7. The pellicle film according to claim 5, wherein a filament of the multi-walled carbon nanotubes has a thickness of from 4 nm to 400 nm.

8. The pellicle film according to any one of claims 1 to 7, which is used for exposure using EUV light.

9. A pellicle comprising:

    the pellicle film according to any one of claims 1 to 8; and
    a support frame supporting the pellicle film.

10. An original plate for exposure comprising: an original plate having a pattern; and the pellicle according to claim 9 attached to a surface of the original plate on a side having the pattern.

11. An exposure device comprising: a light source configured to emit exposure light; the original plate for exposure according to claim 10; and an optical system configured to guide the exposure light emitted from the light source to the original plate for exposure, wherein the original plate for exposure is disposed such that the exposure light emitted from the light source passes through the pellicle film and is applied to the original plate.

12. A method of producing a pellicle, the method comprising:

    preparing carbon nanotubes;
    forming the carbon nanotubes into a sheet shape to produce a carbon nanotube sheet;
    connecting the carbon nanotube sheet to a support frame having an opening so as to cover the opening to produce a pellicle precursor; and
    disposing the pellicle precursor and Si-containing particles in a chamber and heating the chamber at a heating temperature of from 1,200°C to 1,700°C for a heating time of from 5 minutes to 120 minutes.

13. A method of producing a semiconductor device, the method comprising: allowing exposure light emitted from a light source to pass through the pellicle film of the original plate for exposure according to claim 10, to be applied to the original plate, and to be reflected by the original plate; and allowing the exposure light reflected by the original plate to pass through the pellicle film and to be applied to a sensitive substrate to expose the sensitive substrate in a pattern.

# FIG.1

# FIG.2

FIG.3

# FIG.4

## INTERNATIONAL SEARCH REPORT

| | International application No. |
| --- | --- |
| | PCT/JP2021/005738 |

| A. CLASSIFICATION OF SUBJECT MATTER |
| --- |
| G03F 1/62(2012.01)i; G03F7/20(2006.01)i |
| FI: G03F1/62; G03F7/20 503; G03F7/20 521 |
| According to International Patent Classification (IPC) or to both national classification and IPC |

| B. FIELDS SEARCHED |
| --- |

Minimum documentation searched (classification system followed by classification symbols)
G03F1/62; G03F7/20

| Documentation searched other than minimum documentation to the extent that such documents are included in the fields searched | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | JP 2019-168502 A (MITSUI CHEMICALS, INC.) 03 October 2019 (2019-10-03) paragraphs [0030]-[0054], fig. 1-9 | 1-13 |
| A | WO 2019/115218 A1 (ASML NETHERLANDS B.V.) 20 June 2019 (2019-06-20) paragraph [0137], fig. 2 | 1-13 |
| A | JP 2018-194838 A (IMEC VZW) 06 December 2018 (2018-12-06) paragraphs [0051]-[0087], fig. 1-2 | 1-13 |
| A | JP 2018-92155 A (SAMSUNG ELECTRONICS CO., LTD.) 14 June 2018 (2018-06-14) paragraphs [0111]-[0116], fig. 18 | 1-13 |
| A | WO 2018/008594 A1 (MITSUI CHEMICALS, INC.) 11 January 2018 (2018-01-11) paragraphs [0056]-[0073], fig. 1-3 | 1-13 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 12 April 2021 (12.04.2021) | 27 April 2021 (27.04.2021) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

| Patent Documents referred in the Report | Publication Date | Patent Family | Publication Date |
|---|---|---|---|
| JP 2019-168502 A | 03 Oct. 2019 | (Family: none) | |
| WO 2019/115218 A1 | 20 Jun. 2019 | NL 2022080 A<br>TW 201935130 A | |
| JP 2018-194838 A | 06 Dec. 2018 | US 2018/0329291 A1<br>paragraphs [0054]-[0090], fig. 1-2<br>EP 3404486 A1<br>CN 108878259 A | |
| JP 2018-92155 A | 14 Jun. 2018 | US 2018/0149966 A1<br>paragraphs [0143]-[0148], fig. 18<br>EP 3330796 A1<br>KR 10-1813186 B<br>CN 108121153 A<br>KR 10-1813186 B1 | |
| WO 2018/008594 A1 | 11 Jan. 2018 | US 2019/0129300 A1<br>paragraphs [0102]-[0119], fig. 1-3<br>EP 3483655 A1<br>KR 10-2019-0003752 A<br>SG 11201811618R A<br>CN 109416503 A<br>TW 201821359 A | |

**INTERNATIONAL SEARCH REPORT**
Information on patent family members

International application No.

PCT/JP2021/005738

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014142125 A
- WO 2006011655 A
- JP 2020030942 A

**Non-patent literature cited in the description**

- **SAITO et al.** *J. Nanosci. Nanotechnol.,* 2008, vol. 8, 6153-6157